# EUROPEAN PATENT APPLICATION

(11) **EP 4 703 747 A1**
(43) Date of publication of application: **04.03.2026**
(21) Application number: 24196850.2
(22) Date of filing: 28.08.2024
(51) Int. Cl.: G01R 31/319, G06F 3/00, G06F 3/04847, G01R 13/02

(54) **METHOD FOR CONTROLLING A TEST AND/OR MEASUREMENT SYSTEM**

(71) Applicant: Rohde & Schwarz GmbH & Co. KG, 81671 München (DE)
(72) Inventor: MERTKE, Waldemar, 84032 Landshut (DE); EGGESTEIN, Denis, 80809 Munich (DE); WIELANDNER, Angela, 80687 Munich (DE); ZWACK, Josef, 94060 Pocking (DE)
(74) Representative: Rupp, Christian

(57) **Abstract**

The disclosure relates to a method (10) for controlling a test and/or measurement system (100) which comprises a display unit (101) configured to show a numerical control value of the test and/or measurement system. The method (10) comprises activating (11) a first editing mode of the test and/or measurement system, wherein in the first editing mode: a curser element is displayed (11a) at a predefined position with regards to the control value, and the control value is edited (11b) upon receiving a first user input. The method (10) further comprises activating (12) a second edition mode of the test and/or measurement system, wherein in the second editing mode: the position of the cursor element (41) is moved (12a) to a digit of the control value, and a value of said digit is increased or decreased (12b) by a predefined step size upon receiving a second user input.

## Description

### TECHNICAL FIELD

The present disclosure relates to a method for controlling a test and/or measurement system, such as oscilloscope, and to a corresponding test and/or measurement system.

### BACKGROUND

Measurement systems, such as RF measurement devices, can often be adjusted by directly inputting parameter values (e.g., measurement sensitives, ranges, etc.). Often, such measurement systems comprise sensitive measurement hardware which is supposed to react immediately to a change of the parameter value. However, unintentional incorrect entries can lead to damage of the system in extreme cases. Such incorrect entries often occur when users have to enter the value very frequently and within large value ranges.

Furthermore, there is often a large amount of parameter values to be set in a measurement system. It is therefore desirable that the input of these values is simple, fast and intuitive.

### SUMMARY

Thus, it is an objective to provide an improved method for controlling a test and/or measurement system, which avoid the above mentioned disadvantages.

The objective is achieved by the embodiments provided in the enclosed independent claims. Advantageous implementations of the embodiments of the disclosure are further defined in the dependent claims.

According to a first aspect, the present disclosure relates to a method for controlling a test and/or measurement system which comprises a display unit configured to show a numerical control value of the test and/or measurement system. The method comprises: activating a first editing mode of the test and/or measurement system, wherein in the first editing mode: a curser element is displayed at a predefined position with regards to the control value, and the control value is edited upon receiving a first user input. The method further comprises: activating a second edition mode of the test and/or measurement system, wherein in the second editing mode: the position of the cursor element is moved to a digit of the control value, and a value of said digit is increased or decrease by a predefined step size upon receiving a second user input.

This achieves the advantage that the numerical control value (herein also referred to as: control value) of the system can be edited in a simple, fast and intuitive way. In particular, the editing of the control value via a pointing device (e.g., computer mouse or touchpad) or a computer keyboard can be improved.

For example, in the first editing mode, the full control value is increased or decrease by a predefined value (e.g., by a further predefined step size or increment/decrement) upon receiving the first user input. Depending on the predefined value, one or multiple digits of the control value can thereby be adapted at once, allowing for a course adjustment of the control value. In contrast, in the second editing mode, only one digit can be edited at once (i.e., increased or decreased by the predefined step size), allowing for a fine adjustment of the control value.

The first and/or second user input can be received via a user interface of the test and/or measurement system. The user interface can comprise a graphical user interface (GUI) which is displayed by the display unit.

The numerical control value can be a decimal number which can comprise a number of digits in a decimal part and an integer number part. The numerical control value can be a parameter value of the test and/or measurement system.

The control value can control a setting of the test and/or measurement device, such as a sensitivity or a value range. The control value can comprise a number and a measurement unit, such as GHz, which can be shown on the display unit.

The cursor element can be shown as indicated up and down arrows. In the second editing mode, the up and down arrows can be displayed above respectively below the digit of the control value to be edited.

The test and/or measurement system can be implemented by hardware and/or software. For instance, the test and/or measurement system can comprise a test and/or measurement device and/or a software to control test and/or measurement equipment. For instance, the test and/or measurement device can be a signal and/or spectrum analyzer, a signal generator, a network analyzer or an oscilloscope.

In an implementation form of the first aspect, a setting of the test and/or measurement system is adapted according to the change of the control value in the first and/or second editing mode, in particular immediately upon receiving the first and/or second user input.

For instance, the test and/or measurement system can register the change of the control value immediately upon receiving the first and/or second user input and adapt a setting of the test and/or measurement device accordingly.

In an implementation form of the first aspect, a return from the second editing mode to the first editing mode is blocked by the test and/or measurement system. This achieves the advantage that incorrect entries can be avoided.

For instance, the test and/or measurement system can be configured to prevent a direct return from the second to the first editing mode.

In an implementation form of the first aspect, in the first editing mode, the cursor element is displayed in front of the highest positioned digit of the numerical control value.

For instance, the cursor element can be displayed at the position where a next largest digit of the control value would be shown.

In an implementation form of the first aspect, in the second editing mode, if the position of the cursor element is moved above the highest or below the lowest positioned digit of the control value, an additional digit with a value of zero is added to the shown control value at the respective position.

Hereby, the highest and the lowest positioned digit may refer to the leftmost respectively rightmost digit (i.e., at the highest respectively lowest place in the control value).

In an implementation form of the first aspect, the method further comprises activating a third editing mode of the test and/or measurement system, wherein in the third editing mode new values for at least a fraction of the digits of the control value are directly entered via a third user input.

For instance, in the third editing mode, first the fraction of the digits to be edited are selected and then their new values are entered via the direct user input. For instance, direct user input may refer to directly entering values on a hardware or software keyboard or numpad. Also, a fully new value of the control value can be entered in the third editing mode.

For example, in the third editing mode, the new numerical value is set by the test and/or measurement system after completing the input of the direct user input. The input value can be discarded in the third editing mode before the test and/or measurement system changes an internal setting according to the new value.

In an implementation form of the first aspect, which of the first, the second or the third editing mode is activated first is dependent on the type of the control value to be edited and/or a type of user input used for activating the editing mode.

In an implementation form of the first aspect, the method further comprises: displaying a value editor for editing the control value in the first and/or second editing mode.

The value editor can be displayed as a graphical value editor element by the display unit. The value editor can be displayed when activing the first, second and/or third editing mode. The value editor can be an editor menu.

In an implementation form of the first aspect, the value editor comprises a drop-down menu or a popup menu depending on the input device used for activating the first and/or second editing mode.

In addition or alternatively, the value editor is displayed in the form of a drop-down menu or a popup menu depending on the input device used for activating the third editing mode.

In an implementation form of the first aspect, the value editor shows a number of keyboard shortcuts and/or selectable icons for measurement units and/or exponents of the numerical control value; wherein the control value is adapted according to one of the number of measurement units and/or exponents when executing the corresponding keyboard shortcut and/or selecting the corresponding selectable icon (e.g., clicking on the icon).

The selectable icon can be a digital key or button which is displayed by the display unit.

For example, the position of a decimal point (and thus the whole number part and the fractional part of the numerical control value) can be adapted based on the selected measurement unit and/or exponent.

In an implementation form of the first aspect, the adaption of the control value comprises a conversion from an initial measurement unit and/or exponent to the measurement unit and/or exponent corresponding to the executed keyboard shortcut and/or the selected (e.g., clicked-on) icon.

In an implementation form of the first aspect, the method further comprises: issuing a user feedback and/or warning signal if the control value is changed to a value outside of a predefined value range.

According to a second aspect, the present disclosure relates to a computer program product comprising instructions which, when the program is executed by a computer, cause the computer to carry out the method according to the first aspect of the present disclosure.

According to a third aspect, the present disclosure relates to a test and/or measurement system. The test and/or measurement system comprises: a display unit configured to show a numerical control value of the test and/or measurement system; and a user interface for receiving user input. The test and/or measurement system is configured to activate a first editing mode in which: the display unit is configured to display a cursor element at a predefined position with regards to the control value, and the test and/or measurement system is configured to edit the control value upon receiving a first user input on the user interface. Test and/or measurement system is further configured to activate a second editing mode in which: the display unit is configured to move the position of the cursor element to a digit of the control value, and the test and/or measurement system is configured to increase or decrease a value of said digit by a predefined step size upon receiving a second user input on the user interface.

The user interface (UI) can be a graphical user interface (GUI). The GUI can be displayed on the display. The display element can comprise a touch sensitive display for receiving the user input on the GUI.

In an implementation form of the third aspect, the user interface comprises a graphical user interface which is displayed by the display unit, wherein the numerical control value and the cursor element are shown in the graphical user interface.

In an implementation form of the third aspect, the test and/or measurement system is configured to adapt a setting according to the change of the control value in the first and/or second editing mode, in particular immediately upon receiving the first and/or second user input.

In an implementation form of the third aspect, the test and/or measurement system is configured to block a return from the second editing mode to the first editing mode.

In an implementation form of the third aspect, in the first editing mode, the display unit is configured to display the cursor element in front of the highest positioned digit of the numerical control value.

In an implementation form of the third aspect, in the second editing mode, if the position of the cursor element is moved above the highest or below the lowest positioned digit of the control value, the display unit is configured to add an additional digit with a value of zero to the shown control value at the respective position.

In an implementation form of the third aspect, the test and/or measurement system is configured to activate a third editing mode, wherein in the third editing mode new values for at least a fraction of the digits of the control value are directly entered via a third user input on the user interface.

In an implementation form of the third aspect, the test and/or measurement system is configured to activate the first, the second or the third editing mode dependent on the type of the control value to be edited and/or a type of user input used for activating the editing mode.

In an implementation form of the third aspect, the display unit is configured to display a value editor for editing the control value in the first and/or second editing mode.

In an implementation form of the third aspect, wherein the value editor comprises a drop-down menu or a popup menu depending on the input device used for activating the first and/or second editing mode.

In an implementation form of the third aspect, the value editor shows a number of keyboard shortcuts and/or selectable icons for measurement units and/or exponents of the numerical control value; wherein the test and/or measurement system is configured to adapt the shown control value according to one of the number of measurement units and/or exponents when executing the corresponding keyboard shortcut and/or selecting the corresponding selectable icon.

In an implementation form of the third aspect, the adaption of the control value comprises a conversion from an initial measurement unit and/or exponent to the measurement unit and/or exponent corresponding to the executed keyboard shortcut and/or selected icon.

In an implementation form of the third aspect, the test and/or measurement system is configured to issue a user feedback and/or warning signal if the control value is changed to a value outside of a predefined value range.

The above description with regard to the method according to the first aspect of the present disclosure is correspondingly valid for the system according to the third aspect of the present disclosure.

### BRIEF DESCRIPTION OF THE DRAWINGS

The above-described aspects and implementations are explained in the following description of embodiments with respect to the enclosed drawings:
- Fig. 1: shows a flow diagram of a method for controlling a test and/or measurement system according to an embodiment;
- Figs. 2a-7c: show exemplary display content for editing a control value of a test and/or measurement system;
- Figs. 8a-b: show a flow diagram of a method for controlling a test and/or measurement system according to an embodiment;
- Figs. 9a-12: show further exemplary display content for editing a control value of a test and/or measurement system; and
- Fig. 13: shows a schematic diagram of a test and/or measurement system according to an embodiment.

### DETAILED DESCRIPTION OF THE PREFERRED EMBODIMENTS

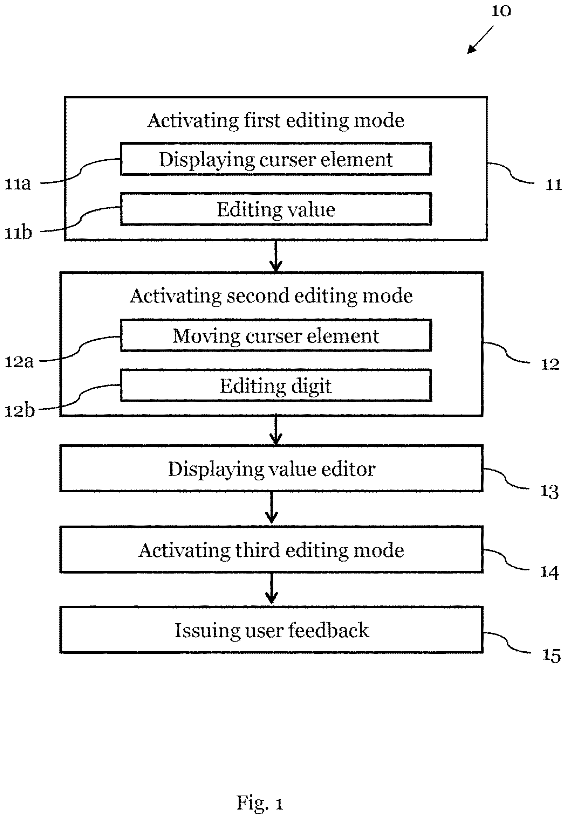

Fig. 1 shows a flow diagram of a method 10 for controlling a test and/or measurement system according to an embodiment. The teas and/or measurement system comprises a display unit configured to show a numerical control value of the test and/or measurement system.

The method 10 comprises activating 11 a first editing mode of the test and/or measurement system, wherein in the first editing mode: a curser element is displayed 11a at a predefined position with regards to the control value, and the control value is edited 11b upon receiving a first user input. The method further comprises activating 12 a second edition mode of the test and/or measurement system, wherein in the second editing mode: the position of the cursor element is moved 12a to a digit of the control value, and a value of said digit is increased or decrease 12b by a predefined step size upon receiving a second user input.

For example, in the first editing mode, the full control value is increased or decrease by a predefined value (e.g., by a further predefined step size or increment/decrement) upon receiving the first user input, while, in the second editing mode, only one digit can be edited at once (i.e., increased or decreased by the predefined step size). Thus, a course adjustment of the control value can be carried out in the first editing mode and a fine adjustment of the control value can be carried out in the second editing mode.

The control value can control a setting of the test and/or measurement device, such as a sensitivity or a value range. The control value can have a measurement unit, such as GHz, which can be shown on the display unit.

The first and/or second editing mode can be activated 11, 12 when receiving a certain user input, e.g., a user clicking on or selecting the displayed control value.

The test and/or measurement system can comprise a test and/or measurement device and/or a software to control test and/or measurement equipment. For instance, the test and/or measurement device can be a signal and/or spectrum analyzer, a signal generator, a network analyzer or an oscilloscope.

For example, a setting of the test and/or measurement system is adapted according to the change of the control value in the first and/or second editing mode. In particular, this setting is adapted immediately upon receiving the first and/or second user input.

In other words: the test and/or measurement system can register the change of the control value immediately upon receiving the first and/or second user input and adapt the setting of the test and/or measurement device accordingly (e.g., after each input which changes the control value by one step size or increment/decrement).

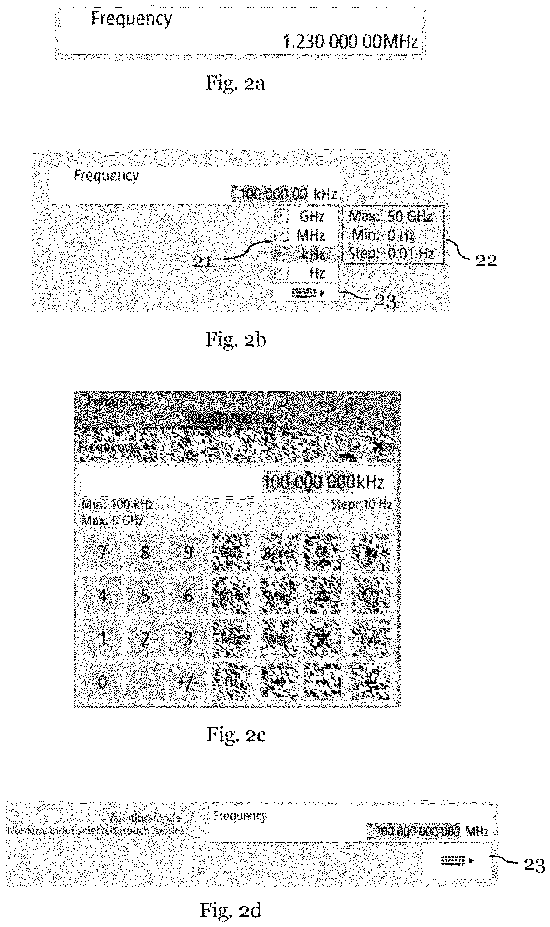

Figs. 2a to 7d shows exemplary display content which can be shown on the display unit of the test and/or measurement device.

For example, the method 10 can comprise displaying 13 a value editor, in particular upon activation of one of the editing modes.

As shown in Fig. 2a, the value editor can show the numerical control value (in this example: 1.230 000 00) of the test and/or measurement system. The value editor can further show a descriptive title (e.g., Frequency) and a corresponding measurement unit (e.g., MHz) of the control value.

In case the control value has a corresponding measurement unit, this unit can be displayed next to its value. Depending on the value range of the control value, a suitable measurement unit with multiple SI prefixes can be shown, e.g. kHz, MHz, or GHz, to facilitate the readability of long values.

The control value can be shown with multiple different and convertible measurement units, e.g. "degree" or "rad" for angular measurements. It is also possible to show the control value with a combination of SI prefixed measurement units and convertible measurement units (e.g., dBm, dBµV, nV, µV, mV, V) . For instance, a user can select a desired measurement unit from a number of units which are offered by the system. When doing so, the control value is converted to the selected measurement unit and displayed accordingly. The display of the control value and the value-editing can then be carried out in the selected measurement unit. However, the editing of the control value according to the method 10 can be carried with control values with and without a corresponding measurement unit.

The value editor can be displayed on a graphical user interface (GUI), which is shown on the display unit of the system. For instance, multiple control values and parameters can be shown simultaneously on the GUI. In order to edit a specific control value or parameter, the value or parameter can be selected by a user and, by this, an editing mode (e.g., the first and/or second editing mode) of the system can be activated. This activation of the editing modes could be done via navigation with a keyboard or a pointing device.

The transition from a purely readable control value to an editable control value may be referred to as opening the value editor, and the transition from an editable control value to an only readable control value may be referred to as closing the value editor.

The value editor can comprise different menus which can be used for editing the control value and/or for showing information with regards to the editing.

For instance, the value editor can comprise a dropdown menu (in the following referred to as: in-place editor) for editing the control value on the spot or a popup menu (in the following referred to as: popup-editor) for editing the control value in a separate editor window. When showing either the in-place editor or the popup-editor, a keyboard can be used to enter numbers, unit-shortcuts and for cursor navigation within the respective editor.

Fig. 2b shows an example of an in-place editor, which is a drop-down menu that can be shown below the control value.

When opening the in-place editor (drop-down menu), possible measurement units can be shown next to the editor in a separate window 21 (so-called unit-popup) for selection. The unit-popup can be shown while the in-place editor is open. If the control value has no unit, no measurement units may be shown.

For instance, as long as the in-place editor is open, a virtual button 23 for opening the popup-editor can be displayed. This virtual button can be integrated in the unit-popup or can be shown independently thereof. Furthermore, the value range and the current step size for editing the control value in the first and/or second editing mode can be displayed (element 22).

Fig. 2c shows an example of a popup editor. Here, the popup editor is a popup menu which can be displayed as an independent window that can overlap the original value editor, in particular the shown numerical value.

For instance, the popup-editor can be freely moved by the user on the display unit. Overlaying the original value editor with the popup menu can be visualized by a darkening of the original value editor, as shown in Fig. 2c.

The popup editor (popup menu) can comprise a virtual keyboard and/or numpad and virtual navigation buttons. The popup editor can further comprise virtual buttons or selectable icons for measurement units, SI prefixes and/or exponents. In this way, the control value can be fully entered by a pointing device (e.g., computer mouse). Furthermore, the popup editor can show the value range and/or current step-size for editing the control value in the first and/or second editing mode.

Whether a popup editor (popup menu) or an in-place editor (dropdown menu) is shown may depend on the input device used for initiating an editing of the control value, i.e., for activating the first and/or second editing mode.

For instance, if the value editor is opened by a keyboard or a mouse click, then the in-place editor is opened. The popup editor can be opened if needed via a virtual button 23, as shown in Fig. 2d.

In case the value editor is opened via a touchscreen input or a predefined keyboard shortcut (e.g., Ctrl-button in combination with left mouse click), the popup editor can be shown directly.

The popup editor can further be opened via a keyboard shortcut or hardkey of the test and/or measurement system.

The first and the second editing mode, can be part of a so-called "variation-mode" of the test and/or measurement system. For instance, in the variation-mode, the control value is increased or decreased in a stepwise manner.

In an example, the test and/or measurement system can further be operated in a third operating mode, which may be referred to as "edit-mode". In the edit-mode, a new control value can be directly entered.

In both variation-modes (i.e., first and second editing mode) and in the edit-mode (i.e., third editing mode, as discussed below), a selection of the value (including measurement unit) may be possible. This may be referred to as "selection mode".

In the following, examples and possible implementations for the variation-mode (i.e., the first and second editing mode) and for the edit-mode (i.e., the third editing mode) are discussed in more detail:

### Variation-mode (i.e., first and/or second editing mode):

In the variation-mode, the control value can be adapted via keyboard (e.g., up/down-cursor buttons), mouse wheel, or rotary encoder of the test and/or measurement system. Thereby, an increment or decrement of the control value can be referred to as "variation step".

In the first and/or second editing mode, each change of the control value can immediately cause a change of a corresponding setting or adjustment parameter of the test and/or measurement device. In other words, a variation step can have a direct effect on the system and, thus, cannot be discarded. For instance, a user can only vary the control value in the opposite direction to return to a previous value.

For example, the variation of the control value in the first and/or second editing mode is only possible within a predefined range that is set by the test and/or measurement system. Only, a value which is generated by variation and which lies within the predefined range might be valid. The variation can be carried out with carryover.

### Sequence of a variation:

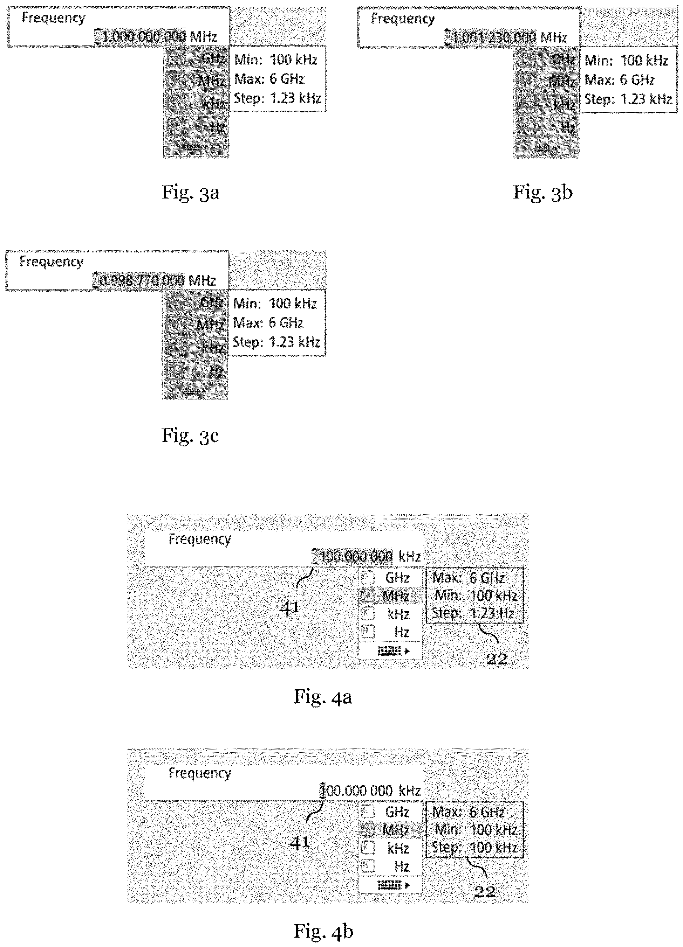

Figs. 3a to 3c show a possible sequence of a variation in the first editing mode.

Thereby, starting from a set control value of 1 MHz (Fig. 3a), the value can be varied (incremented or decremented) with a predetermined step-size of 1.23 kHz. The step-size can be predetermined by the test and/or measurement system for this particular control value.

As shown in Fig. 3b, by the first user input (e.g., clicking an up-cursor key), an increase by one increment (value 1 MHz + step-size of 1.23 kHz) can be triggered and a new value of 1.001 23 MHz can be set. This can be repeated until a maximum control value is set.

As shown in Fig. 3c, by a further first user input (e.g., clicking a down-cursor key) a decrease by one decrement (value 1 MHz - step-size of 1.23 kHz) can be triggered and a new value of 0.998 77 MHz can be set. This can be repeated until a minimum control value is set.

### Step-size:

The step-size during a variation-step can be a currently valid step-size. The direction of the variation (increment or decrement) may determine the sign of the variation-step.

The step-size can be predefined by the test and/or measurement system and/or can be adapted by a user. For instance, the step-size can be predefined according to a starting value, which can then be adapted by the user. The step-size can be displayed next to the in-place editor or the popup editor.

Fig. 4a shows an example where the step-size is predefined by the test and/or measurement system or is suggested as a starting value. In this example, the step-size is 1.23 Hz which is indicated in the window element 22.

In the example shown in Fig. 4a, the first editing mode is activated and the cursor element 41 (also referred to as "variation cursor" in the variation-mode) is displayed in front of the highest positioned digit (i.e., the highest place of a digit in the number) of the numerical control value in the first editing mode.

In the example shown in Fig. 4b, the second editing mode is activated and the curser element 41 is shown at a digit (in this example, at the highest positioned digit of the control number) of the control value. In general, the step-size may correspond to the position of the digit that is selected (in the shown example, each power of 10 between 1 GHz and 1 mHZ depending on the selected digit). In the example of Fig. 4b, the variation curser element 41 is displayed at the 100 kHh digit and thus the step-size is 100 kHz (up or down). However, the cursor element 41 could be moved to a different digit which can cause the step-size to adapt.

If a different measurement unit is selected, the step-size can be adapted accordingly. Further variation-steps can then take place in the selected measurement unit.

The selectable step-sizes can be limited by test and/or measurement system to a suitable range, depending on a value range of the control value.

### Adjusting the step-size:

In particular, in the first editing mode, the highest possible step-size may correspond to the digit place of the highest digit in the highest absolute of the control value within the value range (minimum respectively maximum), and the lowest possible step-size may correspond to the resolution of the test and/or measurement system with regards to the control value.

For instance, in case a control value has the value range from -999 to 10 with a resolution of 0.005, the biggest step-size can be the highest digit place in |-999|, namely 100. The smallest step-size in this example could be 0.005.

### The cursor element:

As shown in Figs. 4a and 4b, the cursor element 41 (also called: "variation cursor") can always be visible in the variation-mode. The variation cursor can be positioned on a digit of the control value or before the control value (i.e., before its highest placed digit).

In the second editing mode, the position of the cursor element 41 at a respective digit can define the step-size which may correspond to the place of the digit in the number of the control value. The smallest possible step-size may not be undercut. By moving the cursor element 41, the step size can be adapted. For instance, the cursor element cannot be placed on a decimal point or a thousand separator.

For instance, the cursor element 41 can only be placed on digits whose place is an allowable step-size according to the test and/or measurement system. The allowed position with the lowest placed digit can result from the place of the highest digit of the smallest step-size.

For instance, the place (or digit place) of the digit 5 in the number 5.123,2 is 1.000. The place (or digit place) of the digit 2 in the same number is 10.

For instance, at a resolution (smallest step-size) of 0.25, the curser element can be placed on the 0.1 place but not the 0.01 place of the control value. The step-size is thereby 0.25.

### Position of the cursor element:

For example, the cursor element 41 can be controlled and/or moved by a user input with a keyboard via the left/right cursor buttons or with a pointing device via a click directly on the digit.

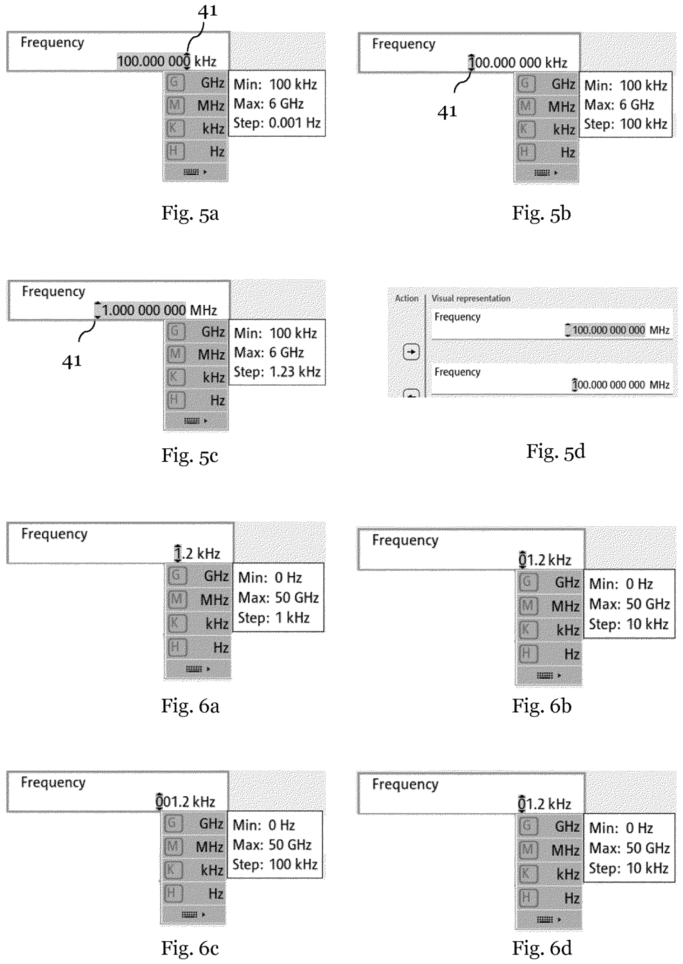

In Fig. 5a, the cursor element 41 is positioned on the 0.0001 Hz place, which also corresponds to the step-size.

In Fig. 5b, the cursor element was moved via a (second) user input to the 100 kHz place. The step-size is now 100 kHz.

Fig. 5c shows an example of the first editing mode, where the cursor element 41 is placed in front of the control value (i.e., in front of the place of its highest value).

### Changing from the first to the second editing mode:

For example, in case the test and/or measurement system supports both the first and the second editing mode for a given control value, the system may start an editing process by first activating the first editing mode. The user can then switch from the first to the second editing mode if required.

By moving the cursor element 41 from the predefined position of the first editing mode (e.g., next to the highest digit), to any specific digit of the control value, the system can switch from the first to the second editing mode, if the second editing mode is allowable.

In the second editing mode, the cursor can be moved to different decimal (or full value) positions to directly change the value at the respective position. For instance, the change of a value at a position can be carried out with an increment/decrement of 1 or a different step-size. However, this can be limited by the smallest step-size (e.g., if the smallest step-size is 10 kHz, the cursor cannot be moved to the 1 kHz digit).

However, the return from this second editing mode to the first editing mode may be blocked by the system. This helps to reduce erroneous value changes.

For instance, in case the control value is set to 100 MHz and the system can operate up to 10 GHz, it can be possible to increase the control value by 1 GHz in one step in the second editing mode. Therefore, the cursor element 41 is moved "to the left" (i.e., to the highest digit place).

However, returning to the first editing mode would also require the cursor element 41 to be moved to the leftmost position. Thus, returning to the first editing mode would be similar to setting the highest step-size in the second editing mode, which might be confusing for a user and could lead to wrong input.

Thus, the system could be adapted, such that for returning from the second to the first editing mode, the entire editing process needs to be ended and restarted.

In each case, the cursor element 41 can be shown as indicated up and down arrows with a place for a digit in the middle.

Fig. 5d shows an exemplary editing of the control value in the first and second editing mode. Thereby, in the first editing mode, the empty cursor element can be displayed to the left of the control value. The entire value can be decreased/increased using up/down arrow keys, a rotary encoder or a mouse wheel. Changes are taken into account directly by the system and do not need to be confirmed separately. The step size can either be predefined by the system (fixed variation-mode) or can be defined individually by the user (outside the editor) (user variation-mode). If the user clicks to the left, the last digit is displayed in the variation-cursor.

If the user now clicks the arrow key to the right, the first digit can be displayed in the variation-cursor. Now the entire value may no longer be adaptable and only the digit within the variation cursor can be changed (with carryover).

### Variation of higher and lower positioned digits:

For the sake of legibility, the control value can be displayed in such a way, that the zeros of the highest placed digits and/or the zeros of the lowest placed digits after the decimal separator are omitted. To use such omitted higher- and lower-placed digits for a variation of the step-size, the cursor element 41 can be moved to these positions via a user input in the second editing mode.

For instance, the cursor can be moved above the highest placed or below the lowest placed digit of the shown control value. As a consequence, the thus-selected places are filled with zeros such that a mathematically correct representation of the control value is achieved. In other words: additional digits with a value of zero can be added to the control value at the respective positions above respectively below the highs/lowest placed digit of the initial control value.

For example, a control value of 1.2 kHz with a value range of 0 Hz to 1 GHz with a resolution of 0.001 Hz can be displayed in the format: "1.2 kHz". To increase the value by 30 kHz to 31.2 kHz by means of a variation (i.e., step-size increase), the cursor element 41 can be moved to the 10 kHz position and subsequently be incremented three time.

Figs. 6a to 6e show an exemplary variation of higher placed digits.

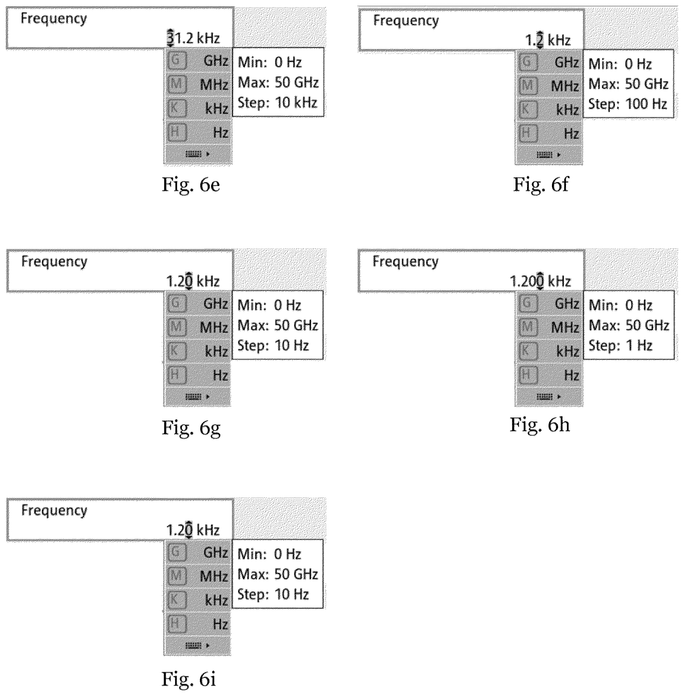

In Fig. 6a, at the start of the editing, the cursor element 41 is positioned at the 1 kHz place. Then, the cursor element 41 is moved via user input to the left to the 10 kHz place, as shown in Fig. 6b. A leading zero is added at the position of the cursor element. By further moving the cursor element 41 to the left, as shown in Fig. 6c, the next higher position (here: 100 kHz) is selected and further leading zeros are added. By moving the cursor 41 back to the right it can be shifted to the next-lower position and the redundant leading zero can be deleted (Fig. 6d). Via a user input for an increment, the value at the 10 kHz position can now be increased three times to 31.2 kHz (Fig. 6e).

Figs. 6f to 6i show an exemplary variation of lower placed digits.

In Fig. 6f, at the start of the editing, the cursor element 41 is positioned at the 100 Hz place. Then, the cursor element 41 is moved via user input to the right to the 10 Hz place, as shown in Fig. 6g. The step-size is adapted accordingly and a lower place zero is added at the position of the cursor element. By further moving the cursor element 41 to the right, as shown in Fig. 6h, the next lower decimal position (here: 1 kHz) is selected and further zeros are added. By moving the cursor 41 back to the left it can be shifted to the next-higher position and the redundant zero can be deleted (Fig. 6i) .

### Edit-mode (third editing mode):

As shown in Fig. 1, the method 10 can further comprise: activating 14 a third editing mode (also referred to as: edit-mode) of the test and/or measurement system.

For instance, in the third editing mode new values for at least a fraction of the digits of the control value are directly entered via a third user input. That is, in the third editing mode, a new control value can be entered, or parts of the current control value can be edited.

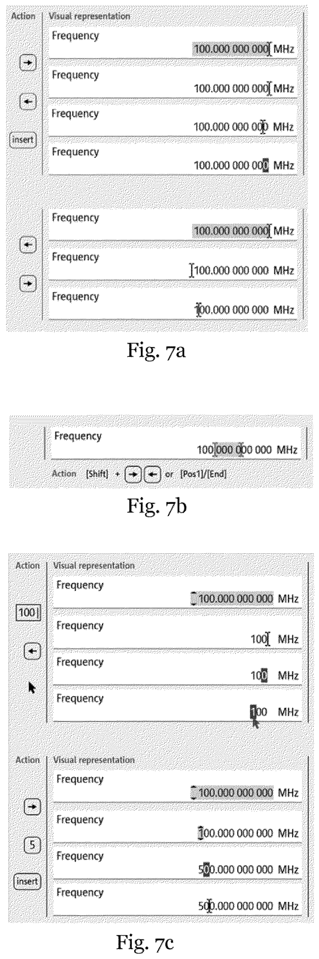

An exemplary editing of the control value in the third editing mode is visualized in Fig. 7a. Optionally, the user can directly access the third editing mode and overwrite a current control value. The entire value can thereby be highlighted (e.g., in blue) and an insert-cursor symbol can be displayed behind the last digit of the control value. The user can move the position of the insert-cursor symbol, e.g., with the arrow keys.

The user can switch between an insert cursor and an overwrite cursor symbol.

The user can then directly enter a new control value (e.g., via a keyboard) which overwrites the current control value.

For instance, in the third editing mode, the change of the control value is only transferred to and/or applied by the measurement system after finalizing the input. This means that an entered or changed value can be discarded in the edit-mode without being set in the test and/or measurement system.

For instance, after inputting a new control value, the input can be checked for plausibility and value range. Values outside of the value range can be discarded by the system or can be automatically adapted to an allowable value.

### Selection-mode:

Furthermore, the entire control value or a sequence of digits of the control value may be selected. In the third editing mode, the thus marked digits can be overwritten by directly inputting new values or can be deleted, e.g., by clicking DEL/backspace on a keyboard. The selected digits could also be copied to a clipboard of an operating system from where they can be copied to a different value editor or a new application.

This selection of specific digits can be referred to as "selection-mode".

Fig. 7b shows an exemplary selection of a number of digits of a control value. The user can thereby use key combinations to mark related areas of the value, which are highlighted (e.g., in blue) (selection mode). Depending on the side from which the user has marked the area (from left to right or from right to left), the insert-cursor can be displayed flashing behind or in front of the marking.

### Changing between modes:

Which of the first, the second or the third editing mode is activated first can be dependent on the type of the control value to be edited and/or a type of user input used for activating the editing mode.

For example, if the control value supports a variation-mode, the variation-mode (e.g., the first or second editing mode) can be activated after a corresponding ENTER or mouse click. If a user starts entering numbers (e.g., via keyboard or numpad), the edit-mode (i.e., third editing mode) can be activated first.

Depending on the configuration of the system, it might not be foreseen to directly change from the edit-mode to the variation-mode. In this case, it might be necessary to end the edit-mode first which resets the entire value editor to its original state.

Fig. 7c shows an exemplary change from the variation-mode to the edit-mode.

For instance, as shown in the top half of Fig. 7c, as soon as the user starts entering digits in variation-mode, the mode switches directly to edit-mode. Now the value might only be taken into account by the system when the user completes the entry with [enter] or the unit key. A flashing insert-cursor can be displayed to the right after the last digit.

Besides the possibility to confirm the new value, the user can also navigate with the arrow keys or the mouse to any position of the newly entered, not yet confirmed, value to overwrite this digit. The selected digit can have a flashing background area (overwrite-cursor).

For instance, as shown in the bottom half of Fig. 7c, if the user clicks with the arrow key to the right or with the mouse directly on any digit, this can be displayed in the variation cursor. If the user now enters a new number (e.g., 5) instead of modifying with inc/dec, the entry is displayed and the digit to the right is shown in the overwrite cursor.

The transition between the modi might depend on the type of control parameter, the configuration of the test and/or measurement system and/or the user input.

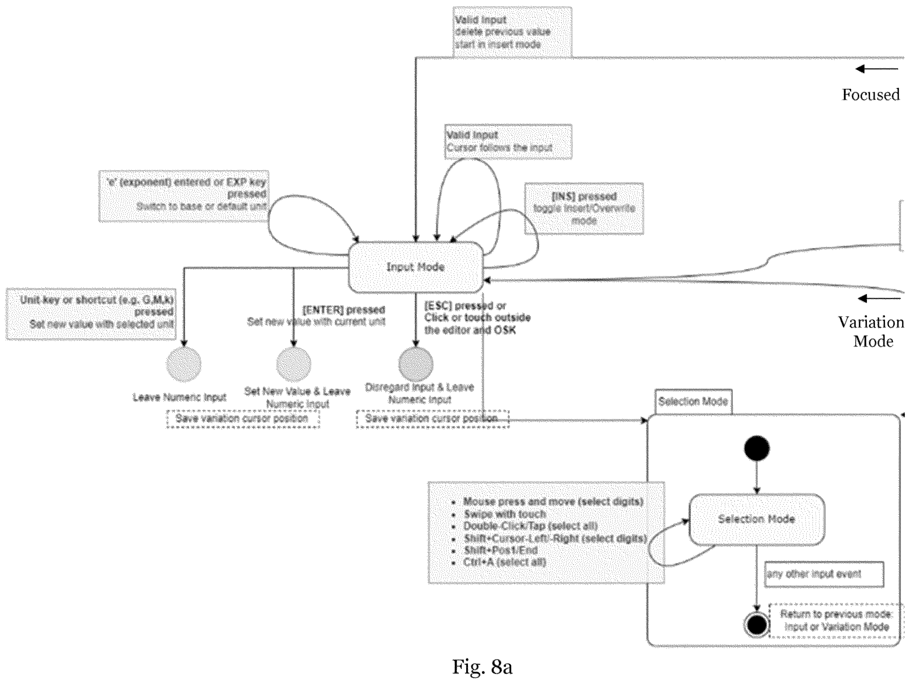

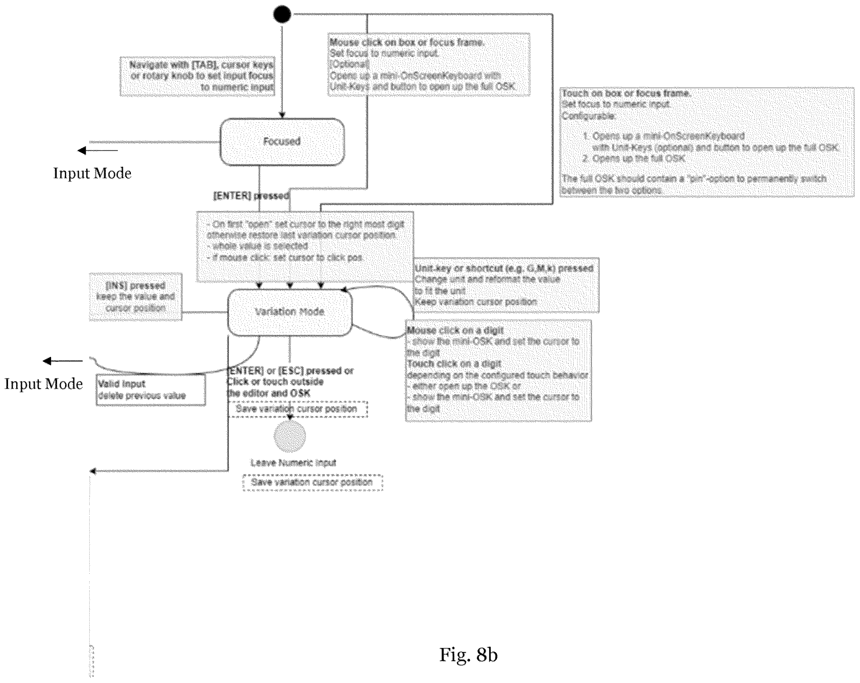

Figs. 8a to 8b show a flow diagram of the method for controlling the test and/or measurement system according to an embodiment. In the flow diagram, the transitions between the different modi are indicated. Fig. 8a and Fig. 8b show the left respectively right sides of the flow diagram, which is divided into the two figures for better readability. The flow diagram is thereby depicted in the form of a "state machine".

### Unit-shortcuts:

A keyboard shortcut can be assigned to each measurement unit with and without an SI prefix (e.g., kilo, Mega, Giga, etc.) or to each exponent (e.g., "× 10⁹" respectively "E+9") . A user can adapt these shortcuts to his or her needs. Such shortcuts will in the following be called unit keyboard shortcuts.

The unit keyboard shortcuts can be displayed in the value editor, in particular in the drop-down editor (in-place editor) and/or in the popup menu (popup editor).

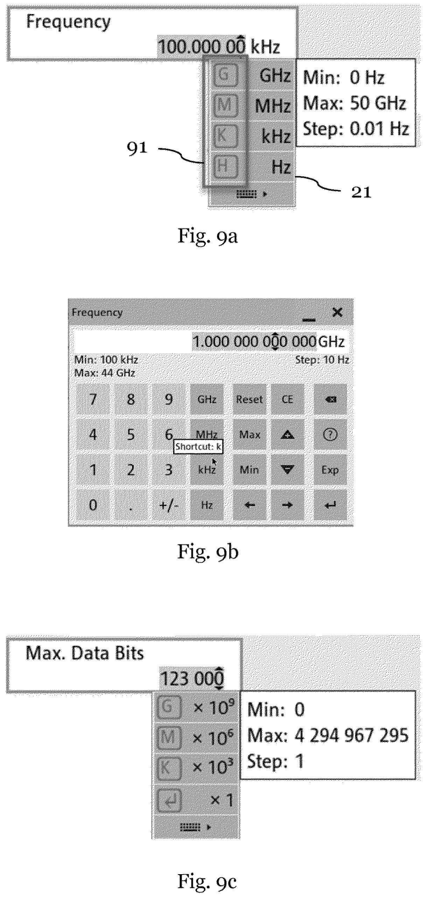

Fig. 9a shows an exemplary in-place editor with unit keyboard shortcuts 91. The unit keyboard shortcuts 91 can be displayed in the unit popup window 21 next to the corresponding units respectively exponents to provide context-related assistance to the user. In the example of Fig. 9a, the keyboard shortcut for "GHz" is the "G" respectively "g" key and the keyboard shortcut for "Hz" is the "H" or "h" key, etc.

In addition or alternatively, the in-place editor can display selectable icons for directly selecting a measurement unit or exponent (e.g., via mouse click or touch input). For instance, the unit keyboard shortcuts 91 and the selectable icons can be displayed in the same place.

Fig. 9b shows an exemplary popup editor, wherein the unit keyboard shortcuts are shown directly on/at the unit-keys or as a tooltip while the mouse pointer hovers over a unit-key.

Fig. 9c shows an exemplary in-place editor with keyboard shortcuts for exponents instead of measurement units. For example, when using control values with a large number of digits with no units or with units that do not use SI prefixes (e.g. frames), exponents can be displayed in the technical notation (e.g., integer multiples of three, such as 10⁻⁶, 10⁻³, ×1, 10³, 10⁶ respectively E-6, E-3, E+0, E+3, E+6). A shortcut can be assigned to each exponent.

### Entering values via unit keyboard shortcuts / selectable icons:

Unit keyboard shortcuts can be used when entering the control value (e.g., in the third editing mode) to complete the entering of the value with its associated measurement unit, SI prefix and/or exponent. The entering of unit-less values with exponents can be carried out analogously to the values with units. This facilitates the entering of long control values with a large number of digits.

In particular, the shown control value can be adapted according to one of the number of measurement units and/or exponents shown in the value editor when executing the corresponding keyboard shortcuts and/or clicking on the corresponding selectable icon.

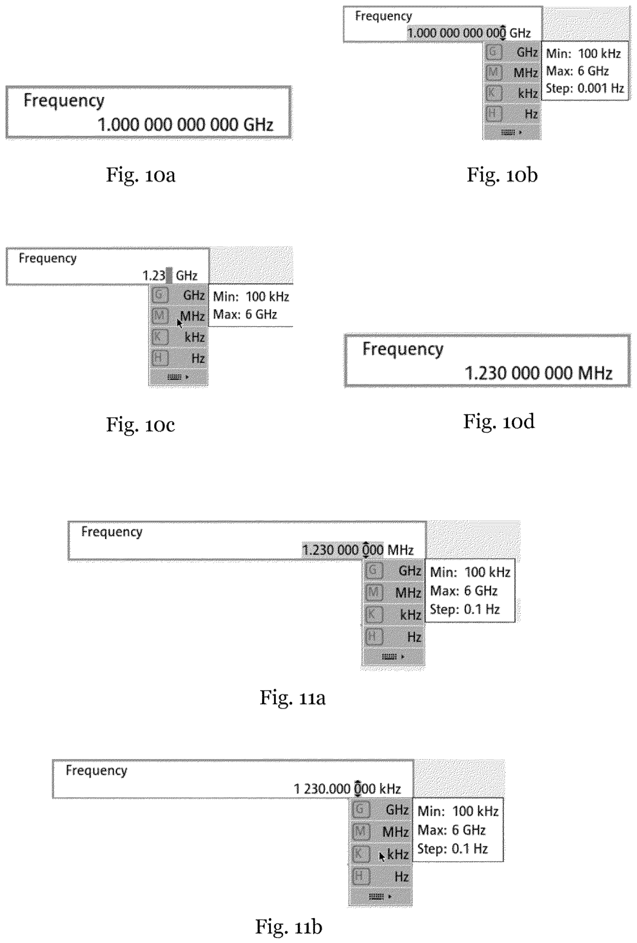

In the example shown in Figs. 10a to 10d, a frequency of 1.23 MHz is entered starting from an initially set frequency of 1 GHz.

Fig. 10a shows the value of 10 GHz which is currently set by the test and/or measurement system, and which can be shown in the GUI. In this example, the value can be set exactly to 0.001 Hz, the control value is shown with all valid digits (1.000 000 000 000 GHz).

A user can click on this control value with a computer mouse or put the input focus on the value and click the ENTER-key. This can open the in-place editor which allows editing the value (Fig. 10b).

The user can enter die number "1.23" via the keyboard, as shown in Fig. 10c. However, this value is not yet set in the test and/or measurement system.

The user can then click on a selectable icon with the unit "Mhz" or the user can press on the shortcut key on a keyboard (in Fig. 10c, e.g., the letter "m" respectively "M").

This can complete the entering of the new control value. Thus, the in-place editor can be closed. The new value "1.23" can be set by the test and/or measurement system and can be displayed in the GUI (in a defined format, e.g., precise up to 0.001 Hz) as shown in Fig. 10d.

### Conversion into different units:

The adaption of the control value can comprise a conversion from an initial measurement unit and/or exponent to the measurement unit and/or exponent corresponding to the executed keyboard shortcut and/or clicked-on selectable icon.

For instance, in the variation-mode (first and/or second editing mode), the shown value can be converted to a different measurement unit (or exponent) by clicking the unit keyboard shortcut or selecting the unit in the unit popup window 21.

For instance, as shown in Fig. 11a, when opening the value editor, the control value in MHz is 1.230 000 000 MHz.

When selecting a different SI prefix (here: kHz) via the unit keyboard shortcut ("k") or via a click on the selectable icon for "kHz" in the popup window 21, the current value is converted to 1 230.000 000 kHz, as shown in Fig. 11b.

### User feedback:

Optionally, as shown in Fig. 1, the method can comprise issuing 15 a user feedback and/or warning signal if the control value is changed to a value outside of a predefined value range.

The user feedback can be used to inform the user that a note or indication exists for the control value in the test and/or measurement system. For example, the set control value can lie out of an allowable value range, such that the system cannot set the value. The allowable value range can be fixed by the test and/or measurement system or can depend on other control parameters and/or from external influences on the test and/or measurement system.

Furthermore, the test and/or measurement system may allow control value outside of a technical norm or a guaranteed measuring accuracy. By means of the user feedback, the user can be informed about the exact reason therefore.

In addition, the control value might not be editable at the moment due to any particular reason. Also, this could be reported to the user via the user feedback.

In case of a system message, the value editor can be color coded according to the urgency of the message or can be provided with a symbol or a textual hint. Typically, states that cause a user feedback are, e.g., hints, warnings or errors. As such, the user feedback can be a warning signal or message.

A textual hint can be shown next to the value editor. After a timeout or a user interaction, this textual hint can be made invisible. Thereby, the color coding and/or a symbol for the urgency of the message can be further displayed, as long as the message is present.

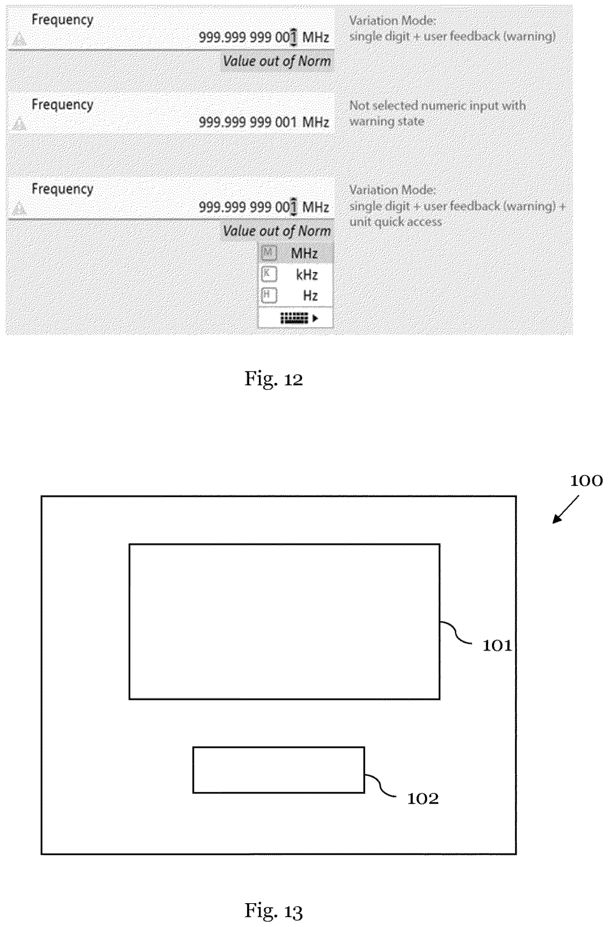

Fig. 12 shows an exemplary issuing of a warning in the in-place editor.

Fig. 13 shows a schematic diagram of a test and/or measurement system 100 according to an embodiment. For instance, the test and/or measurement system 100 can be configured to carry out the method 10 according to Fig. 1.

The test and/or measurement system 100 comprises: a display unit 101 configured to show the numerical control value of the test and/or measurement system 100; and a user interface 102 for receiving user input; wherein the test and/or measurement system 100 is configured to activate the first editing mode in which: the display unit 101 is configured to display the cursor element 41 at a predefined position with regards to the control value, and the test and/or measurement system 100 is configured to edit the control value upon receiving the first user input on the user interface 102. The test and/or measurement system 100 is further configured to activate the second editing mode in which: the display unit 101 is configured to move the position of the cursor element 41 to a digit of the control value, and the test and/or measurement system 100 is configured to increase or decrease a value of said digit by a predefined step size upon receiving the second user input on the user interface 102.

The user interface 102 can comprise any interface suitable for receiving user input, e.g., a control element of the test and/or measurement system 100, or a mouse and/or keyboard or an interface for connecting the same to the test and/or measurement system 100.

For example, the user interface 102 comprises a graphical user interface which is displayed by the display unit 101, wherein the numerical control value and the cursor element 41 are shown in the graphical user interface.

The display unit 101 can be a touch-sensitive display. For instance, the user input can be received via a tough input on the touch-sensitive display.

The test and/or measurement system 100 can activate the first and/or second editing mode upon receiving a certain input, e.g., a user clicking on or selecting the displayed control value.

The test and/or measurement system 100 can be configured to adapt a setting (e.g., an internal setting) according to the change of the control value in the first and/or second editing mode, in particular immediately upon receiving the first and/or second user input.

The test and/or measurement system 100 can comprise a test and/or measurement device and/or a software to control test and/or measurement equipment. For instance, the test and/or measurement device can be a signal and/or spectrum analyzer, a signal generator, a network analyzer or an oscilloscope.

While various embodiments of the present disclosure have been described above, it should be understood that they have been presented by way of example only, and not limitation. Numerous changes to the disclosed embodiments can be made in accordance with the disclosure herein, without departing from the spirit or scope of the disclosure. Thus, the breadth and scope of the present disclosure should not be limited by any of the above described embodiments. Rather, the scope of the disclosure should be defined in accordance with the following claims and their equivalents.

Although the disclosed embodiments have been illustrated and described with respect to one or more implementations, equivalent alterations and modifications will occur or be known to others skilled in the art upon the reading and understanding of this specification and the annexed drawings. In addition, while a particular feature of the present disclosure may have been disclosed with respect to only one of several implementations, such feature may be combined with one or more other features of the other implementations as may be desired and advantageous for any given or particular application.

## Claims

1. A method (10) for controlling a test and/or measurement system (100) which comprises a display unit (101) configured to show a numerical control value of the test and/or measurement system, the method comprising:
activating (11) a first editing mode of the test and/or measurement system, wherein in the first editing mode:
- a curser element is displayed (11a) at a predefined position with regards to the control value, and
- the control value is edited (11b) upon receiving a first user input;
activating (12) a second edition mode of the test and/or measurement system, wherein in the second editing mode:
- the position of the cursor element (41) is moved (12a) to a digit of the control value, and
- a value of said digit is increased or decreased (12b) by a predefined step size upon receiving a second user input.

2. The method (10) of claim 1,
wherein a setting of the test and/or measurement system (100) is adapted according to the change of the control value in the first and/or second editing mode, in particular immediately upon receiving the first and/or second user input.

3. The method (10) of claim 1 or 2,
wherein a return from the second editing mode to the first editing mode is blocked by the test and/or measurement system.

4. The method (10) of any one of the preceding claims,
wherein, in the first editing mode, the cursor element (41) is displayed in front of the highest positioned digit of the numerical control value.

5. The method (10) of any one of the preceding claims,
wherein, in the second editing mode, if the position of the cursor element (41) is moved above the highest or below the lowest positioned digit of the control value, an additional digit with a value of zero is added to the control value at the respective position.

6. The method (10) of any one of the preceding claims, further comprising:
activating (14) a third editing mode of the test and/or measurement system, wherein in the third editing mode new values for at least a fraction of the digits of the control value are directly entered via a third user input.

7. The method (10) of claim 6,
wherein which of the first, the second or the third editing mode is activated first is dependent on a type of the control value to be edited and/or a type of user input used for activating the editing mode.

8. The method (10) of any one of the preceding claims, further comprising:
displaying (13) a value editor for editing the control value in the first and/or second editing mode.

9. The method (10) of claim 8,
wherein the value editor comprises a drop-down menu or a popup menu depending on the input device used for activating the first and/or second editing mode.

10. The method (10) of claim 8 or 9,
wherein the value editor shows a number of keyboard shortcuts and/or selectable icons for measurement units and/or exponents of the numerical control value;
wherein the control value is adapted according to one of the number of measurement units and/or exponents when executing the corresponding keyboard shortcut and/or selecting the corresponding selectable icon.

11. The method (10) of claim 10,
wherein the adaption of the control value comprises a conversion from an initial measurement unit and/or exponent to the measurement unit and/or exponent corresponding to the executed keyboard shortcut and/or the selected icon.

12. The method (10) of any one of the preceding claims, further comprising:
issuing (15) a user feedback and/or warning signal if the control value is changed to a value outside of a predefined value range.

13. A computer program product comprising instructions which, when the program is executed by a computer, cause the computer to carry out the method (10) according to any one of the preceding claims.

14. A test and/or measurement system (100), comprising:
a display unit (101) configured to show a numerical control value of the test and/or measurement system; and
a user interface (102) for receiving user input;
wherein the test and/or measurement system (100) is configured to activate a first editing mode in which:
- the display unit (101) is configured to display a cursor element (41) at a predefined position with regards to the control value, and
- the test and/or measurement system (100) is configured to edit the control value upon receiving a first user input on the user interface (102);
wherein the test and/or measurement system (100) is further configured to activate a second editing mode in which:
- the display unit (101) is configured to move the position of the cursor element (41) to a digit of the control value, and
- the test and/or measurement system (100) is configured to increase or decrease a value of said digit by a predefined step size upon receiving a second user input on the user interface (102).

15. The test and/or measurement system (100) of claim 13,
wherein the user interface (102) comprises a graphical user interface which is displayed by the display unit (101);
wherein the numerical control value and the cursor element (41) are shown in the graphical user interface.
